Europäisches Patentamt

(19) European Patent Office

Office européen des brevets

(11) Publication number: **0 259 163**
**A2**

# (12) EUROPEAN PATENT APPLICATION

(21) Application number: **87307786.1**

(22) Date of filing: **03.09.87**

(51) Int. Cl.⁴: **G 01 R 1/073**
**H 01 R 11/18**

(30) Priority: **05.09.86 US 904738**

(43) Date of publication of application:
**09.03.88 Bulletin 88/10**

(84) Designated Contracting States: **DE FR GB NL**

(71) Applicant: **TEKTRONIX, INC.**
**Howard Vollum Park 14150 S.W. Karl Braun Drive P.O. Box 500**
**Beaverton Oregon 97077 (US)**

(72) Inventor: **Rath, Dale R.**
**Star Route Box 322A**
**Gales Creek Oregon 97117 (US)**

(74) Representative: **Burke, Steven David et al**
**R.G.C. Jenkins & Co. 26 Caxton Street**
**London SW1H 0RJ (GB)**

(54) Semiconductor wafer probe.

(57) A flexible thin film probe head extends below a probe frame and supports a plurality of wafer contact bumps in planar array. An elastic member is positioned between a rigid plate and the surface of the thin film opposite the contact bumps so as to provide a controlled pressure interconnect between the I/O pads on the wafer and the contact bumps. Interface between the contact bumps and external test equipment is made through constant impedance transmission lines on the probe head and on an adjoining substrate. The two sets of transmission lines are coupled together by mechanical pressure contacts so as to facilitate the substitution of other probe heads having different wafer I/O pad configurations. Interface between the transmission lines on the printed circuit board and a set of semirigid coaxial cables is made by a second pressure interface so as to simplify assembly of the unit.

FIG. 1

**Description**

## SEMICONDUCTOR WAFER PROBE

### TECHNICAL FIELD

The present invention relates to probes for multilead testing of IC wafers.

### BACKGROUND OF THE INVENTION

An important step in the production of integrated circuits is to test each circuit to determine whether it has properly been manufactured. It is generally desirable to conduct such testing as early as possible in the fabrication process. The earliest this can be done is after wafer fabrication is completed, before separation into dice. The next opportunity is to test the dice before they are packaged. In either case, it is necessary to make electrical connection to all of the circuit's external connections (usually bonding pads) in a nondestructive way so that normal packaging and connection is subsequently possible.

It is also desirable to test the circuit both at its normal operating conditions and at the extremes of its performance range. For high speed circuits, such as those having signal bandwidths exceeding one GHz, it is important to be able to evaluate circuit operation at full speed. In the past, this has been difficult or impossible due to bandwidth limitations of conventional wafer probes.

Conventional wafer probes generally comprise a platform onto which is mounted a plurality of downwardly extending silver wire styli for contacting the wafer. The bandwidth of such probes is severely limited by crosstalk between the styli and styli inductance.

A prior art probe by Cascade Microtech attempted to overcome the bandwidth limitations of conventional IC probes by using transmission line conductors and microwave absorbing material. In so doing, however, other drawbacks were introduced. Principal among these is that only 44 wafer pads can be probed, due to the bulky nature of the probing styli. As a further drawback, each stylus generally requires expert manual adjustment for proper positioning. Finally, the Cascade Microtech device is quite fragile and prohibitively expensive.

Accordingly, a need remains for an improved method and apparatus for probing semiconductor wafers.

### SUMMARY OF THE INVENTION

It is an object of the present invention to provide a versatile probing apparatus that can probe semiconductor dies and wafers having hundreds of I/O contacts at multi-gigahertz bandwidths.

It is another object of the present invention to provide an integrated circuit probe that allows the user to replace the probe head quickly with other probe heads for different wafer I/O pad configurations.

It is still another object of the present invention to provide a wafer probe in which wafer contact pressure is moderated by an elastic member.

It is yet another object of the present invention to provide an interface between a coplanar transmission line and a semirigid coaxial cable that is devoid of metal bonding points so as to facilitate assembly of a wafer probe.

According to the present invention, a flexible thin film probe head extends below a probe frame and supports a plurality of wafer contact bumps in planar array. An elastic member is positioned between a rigid plate and the surface of the thin film opposite the contact bumps so as to provide a controlled pressure interconnect between the I/O pads on the wafer and the contact bumps. Interface between the contact bumps and external test equipment is made through constant impedance transmission lines on the probe head and on an adjoining substrate. The two sets of transmission lines are coupled together by mechanical pressure contacts so as to facilitate the substitution of other probe heads having different wafer I/O pad configurations. Interface between the transmission lines on the printed circuit board and a set of semirigid coaxial cables is made by a second pressure interface so as to simplify assembly of the unit.

The foregoing and additional objects, features and advantages of the present invention will be more readily apparent from the following detailed description of a preferred embodiment thereof, which proceeds with reference to the accompanying drawings.

### BRIEF DESCRIPTION OF THE DRAWINGS

Fig. 1 shows an exploded view of a wafer probe in accordance with the present invention.

Fig. 2 is a bottom plan view of the probe of Fig. 1.

Fig. 3 shows a piece of polyimide film cut for later formation into a truncated pyramidal probe head.

Fig. 4 is an enlarged fragmentary bottom plan view showing a probe head and its interface with the substrate.

Fig. 5 is a sectional view of an assembled probe taken along lines 5-5 of Fig. 1.

Fig. 6 is a sectional view taken along lines 6-6 of Fig. 5 showing the interface between a coplanar transmission line and a semirigid coaxial cable.

Fig. 7 is an enlarged fragmentary view of a transmission line substrate used to link the probe head conductor to the semirigid coaxial cables.

### DETAILED DESCRIPTION OF A PREFERRED EMBODIMENT

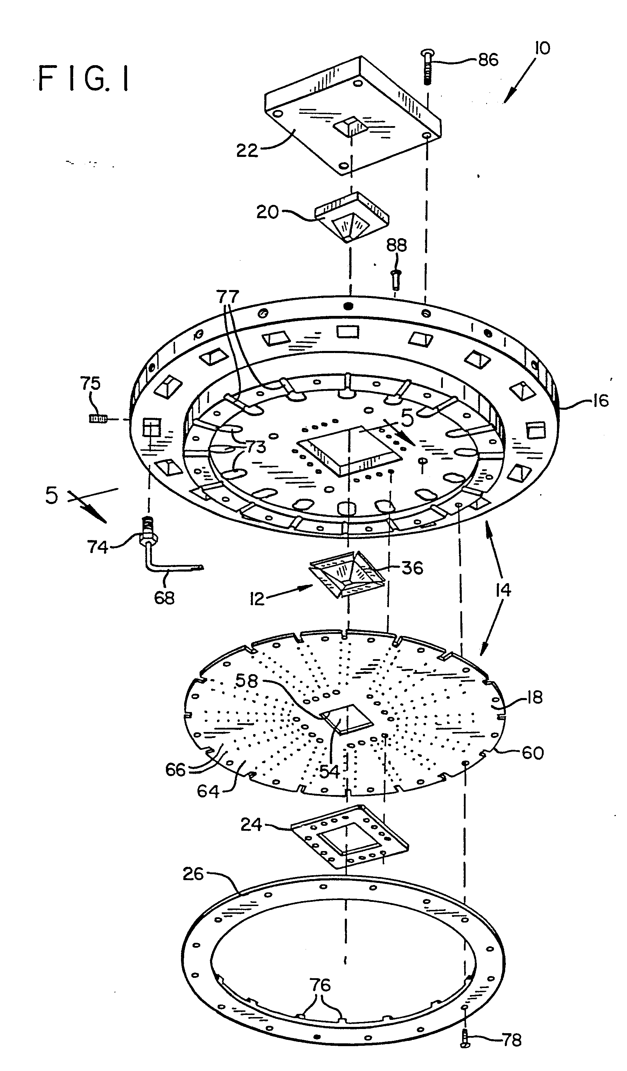

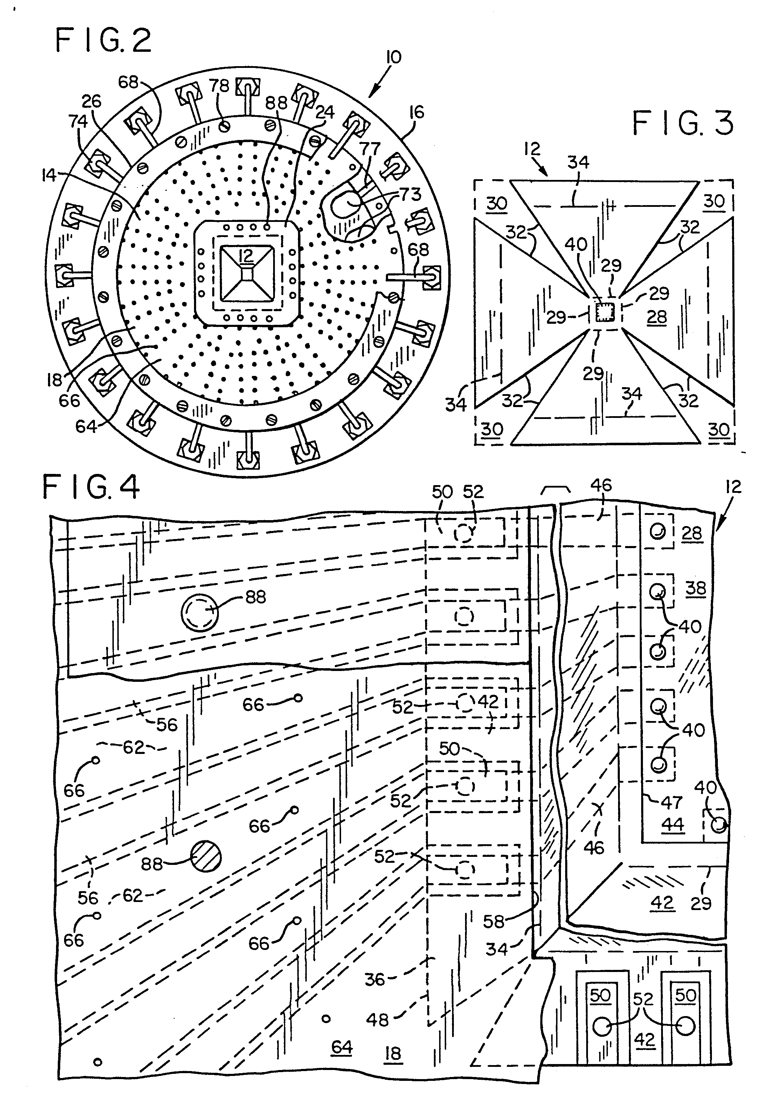

With reference to Fig. 1, an illustrative probe 10 according to the present invention includes a replaceable polyimide probe head 12 mounted in a supporting and connecting structure 14. Structure 14 includes a support frame 16, a transmission line substrate 18, a molded rubber insert 20, a clear plastic plate 22, a backing plate 24 and a clamping ring 26. Fig. 2 is a bottom view showing the probe of Fig. 1 in assembled form.

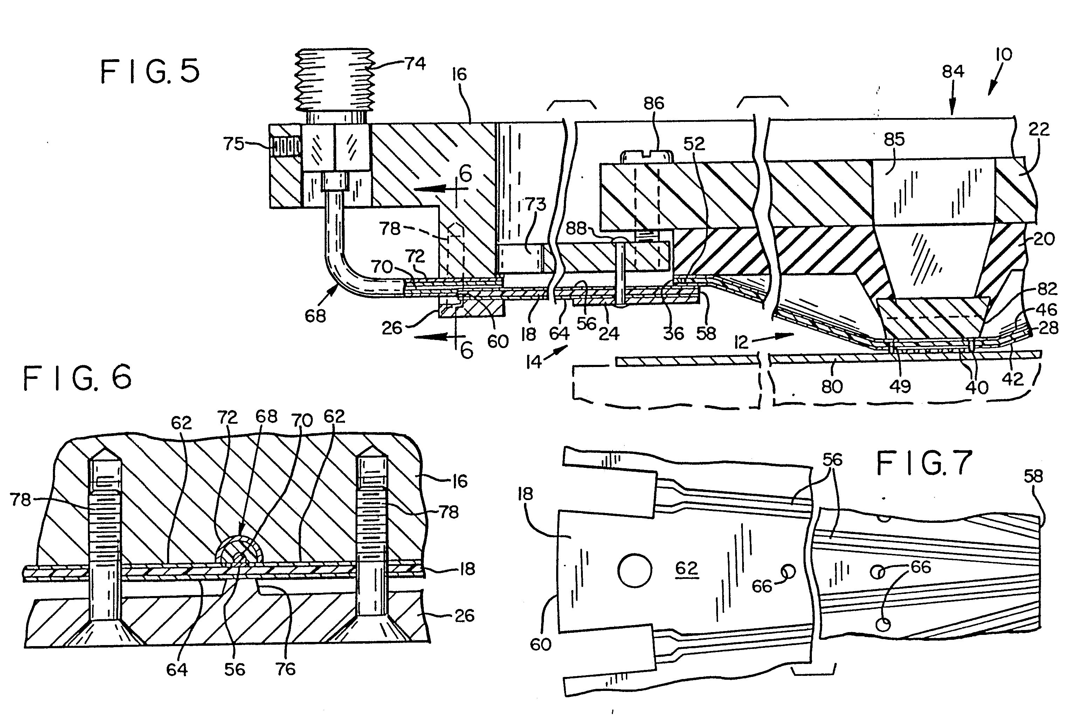

With reference to Fig. 3, probe head 12 begins as a planar sheet of low loss thin film 28, such as polyimide, from which inwardly extending regions 30 are removed. These cuts allow the remaining adjacent edges 32 to be bent downwardly along first bend lines 29 and bonded together so as to form a truncated pyramidal geometry. Edges 32 are glued together only so far as second bend lines 34. The trapezoidal sides of the truncated pyramid are then bent along second bend lines 34 to provide probe head 12 with a planar lip 36 (Figs. 1, 5) around its large rectangular opening.

Fig. 4 is a bottom view showing an enlarged fragment of probe head 12 and its interface with transmission line substrate 18. Probe head 12 has a planar contact supporting surface 38 onto which a plurality of nickel wafer contact bumps 40 are formed. Contact bumps 40 are positioned on surface 38 in a pattern that matches the corresponding pattern of I/O pads on the wafer to be probed. (In alternative embodiments, polyimide film 28 can have a hole in lieu of a flat planar truncation surface and contacts 40 can be mounted along the perimeter of this hole).

In the illustrated embodiment, a ground plane conductor 42 is formed on the downward facing surface 44 of polyimide film 28. Ground plane conductor 42 covers the four trapezoidal sides of probe head 12 and terminates at an edge 47 adjacent the contact supporting surface 38. On the opposite side of film 28 are formed a plurality of gold microstrip lines 46 which extend from outer peripheral edge 48 of film 28 to positions opposite nickel contacts 40, just beyond edge 47 of ground plane 42. Microstrip conductors 46, in conjunction with ground plane 42, thus form constant impedance transmission lines which lead from contacts 40 to peripheral edge 48 of probe head 12. Nickel contacts 40 are connected to conductors 46 by plated vias 49 (Fig. 5) that extend through film 28.

In the preferred embodiment, ground plane conductor 42 is positioned on the bottom side of the probe and signal conductors 46 are positioned on the top so as to prevent parasitic coupling between the signal conductors and the wafer. In other embodiments, however, the reverse arrangement could be used. Alternatively, entirely different transmission line geometries could be used, such as coplanar, composite strip-coplanar, embedded microstrip, etc.

Ground plane 42 is partially removed near outer peripheral edge 48 of probe head 12 so as to leave a plurality of contact pads 50 on the lower surface of lip 36. Conductors 46 extend to peripheral edge 48 of film 28 opposite pads 50 and connect thereto by plated-through holes 52. By this technique, lower surface 44 of probe head 12 has, at its periphery, pads 50 which are connected to the contact bumps 40, which pads are bordered on three sides by ground plane 42.

The three dimensional geometry of probe head 12 allows wafer contact bumps 40 to be spaced well below the lowest portions of associated mounting structure 14. This position minimizes coupling between the wafer and mounting structure 14 and further allows the probe to be positioned over any portion of a wafer without physical interference between the wafer and structure 14.

Probe head 12 is adapted to be receivably mounted within an opening 54 (Fig. 1) in substrate 18. With reference to Figs. 4 and 7, illustrated substrate 18 is a Fiberglas reinforced Teflon circuit board onto a first, upper surface of which are formed a plurality of coplanar transmission line conductors 56 extending radially from an inner peripheral edge 58 to an outer peripheral edge 60. Each transmission line conductor 56 is positioned between two coplanar ground conductors 62 and opposite a metal ground plane 64 which covers a second, lower surface of substrate 18. A multitude of plated-through holes 66 connect ground plane 64 to ground conductor 62. Transmission line conductors 56, operated in conjunction with ground conductor 62 and ground plane 64, form constant impedance transmission lines having an impedance that matches the impedance of the probe head transmission lines to which they are coupled.

The terminations of coplanar transmission line conductors 56 at inner periphery 58 of substrate 18 are spaced to correspond with the spacing of conductor pads 50 on the peripheral lip of probe head 12. When the peripheral lip of probe head 12 is pressed against the inner periphery of substrate 18, conducting pads on probe head 50 make contact with conductors 56 on substrate 18, and ground plane 42 bordering conductor pads 50 makes contact with ground conductors 62 on substrate 18. The transmission lines on probe head 12 are thus connected to their counterparts on substrate 18, forming a series of constant impedance transmission lines linking wafer contact bumps 40 to the outer periphery of substrate 18. Bandwidth limitations introduced by bond wire connections used in the prior art are consequently avoided.

Fig. 5 is a cross-sectional view taken along lines 5-5 of Fig. 1 showing, inter alia, the arrangement that causes contacts 40 resiliently to deflect when urged against a wafer 80. In the illustrated embodiment, molded rubber insert 20 resiliently couples inelastic plastic plate 22 to the portion of film 28 opposite contacts 40. A clear plastic insert 82 is molded to the bottom of the cone shaped portion of rubber insert 20 and transfers the resilient force from rubber insert 20 uniformly to the contact supporting portion of polyimide film 28.

In the preferred embodiment, polyimide film 28 is transparent, thereby enabling the operator to align contacts 40 over the corresponding portions of integrated circuit 80 by looking down along viewing axis 84 through a microscope. In alternative embodiments, the truncated conical cavity within molded rubber insert 20 can be omitted with only some sacrifice in optical resolution if insert 20 is formed of clear silicone rubber. Similarly, the viewing hole 85 in inelastic plastic plate 22 can be omitted if plate 22 is formed of a transparent material such as Plexiglas. (If probe 10 is used in fully automated test equipment, of course, probe head 12 is aligned by a machine using wafer mapping, so the clear optical path through the probe can be omitted.)

Plastic plate 22, in cooperation with bolts 86 threaded into frame 16 at each of the four corners of plate 22, serves the dual function of holding molded rubber insert 20 in compression and forcing together inner peripheral edge 58 of substrate 18 against peripheral lip 36 of probe head 12. This compressive force establishes the pressure contact between the probe head transmission lines and the substrate transmission lines, noted above.

In alternative embodiments, an electromechanical system can be substituted for rubber insert 20 in order to limit the force applied to wafer 80 by wafer contact bumps 40. A suitable electromechanical system is disclosed in my copending application Serial No. 903,356, filed 3rd September 1986, entitled Pressure Control Apparatus for Use in an Integrated Circuit Testing Station. A copy of that application is being filed herewith as an appendix. In such embodiment, alternative means are provided to hold the transmission line conductors of probe head 12 firmly in contact with their counterparts on substrate 18.

Substrate 18, which is normally of a material such as Teflon, will cold flow and move downwardly in response to the force applied to it by rubber insert 20 and bolts 86 if this force is exerted for extended periods of time. Such downward flow of the Teflon substrate would tend to interrupt the connection between the transmission lines on probe head 12 and the transmission lines on substrate 18. To avoid such cold flow, brass back plate 24 is used to limit the downward movement of substrate 18. Back plate 24 is held in place by a plurality of brads 88 which join to frame 16.

In other embodiments, it may be desirable to cut from the center of the contact supporting portion of film 28 a hole through which ink can be applied to mark inoperative dies. Automatic assembly equipment could then recognize the marked dies and reject them for further processing.

Fig. 6 shows the interconnection between one of the transmission lines 56 on substrate 18 and a semirigid coaxial cable 68. Coaxial cable 68 is cut at its end along a plane substantially parallel to its longitudinal axis so as to expose a planar surface that includes the center conductor 70 and the outer conductor 72. This exposed planar surface is pressed against coplanar transmission line 56 on substrate 18 so as to establish a pressure contact between the corresponding elements of the transmission lines. Ground 72 of cable 68 and ground conductor 62 on substrate 18 are pressure connected, as are center conductor 70 of cable 68 and conductor 56 on substrate 18. The connecting pressure is effected by clamping ring 26 which includes a plurality of raised ribs 76 spaced to correspond with the conductors 56 on substrate 22. Clamping ring 26, in conjunction with a plurality of bolts 78, presses raised rib 76 against the portion of substrate 18 opposite cable 68. Raised rib 76 concentrates the applied pressure onto the corresponding elements of the coaxial cable and the coplanar transmission line so as to urge contact therebetween. Support frame 16 includes a plurality of radial cuts 77 (Fig. 1) about its periphery for receiving the semicircular cross section of the cut semirigid cable and providing a rigid backing member against which contact between the corresponding transmission lines can be urged.

Frame 16 is cast with holes 73 (Figs. 1, 2, 5) to allow visual access to the junction between the semirigid coaxial cable 68 and the coplanar transmission lines on substrate 18. Each semirigid coaxial cable 68 terminates in a female SMA coaxial connector 74 which is held in a hole in frame 16 by a set screw 75. The electronic equipment that tests the semiconductor wafer is interfaced to the probe through SMA connectors 74.

While the preceding has described a preferred embodiment, it will be appreciated that the present invention is not so restricted. Variations can be made in the illustrated structure without departing from the scope of the invention as defined in the appended claims and equivalents thereof. For example, probe head 12 can be comprised of several layers of film interspersed with several layers of conductors, so as to facilitate connection to large numbers of contact bumps configured in grid arrays. Similarly, substrate 18 can comprise a multilayer laminate to increase the number of transmission lines that can interface with the probe head. I claim as my invention all modifications coming within the scope and spirit of the following claims.

## Claims

1. An apparatus for probing an integrated circuit comprising:

a probe frame below which the integrated circuit is to be positioned;

a plurality of electrical contact means for making electrical contact with the integrated circuit;

three dimensional insulating support means mounted on the probe frame for supporting on a contact supporting portion thereof the plurality of electrical contact means in a common first plane, said first plane being located below the probe frame; and

a plurality of first conductor means for connecting to the plurality of electrical contact means, said plurality of first conductor means extending along the insulating support means and terminating adjacent a peripheral edge thereof on a second plane parallel to and spaced above the first.

2. The probe of claim 1 in which the plurality of first conductor means comprise transmission lines each including a transmission line conductor on a first side of the support means operated in conjunction with a ground plane conductor on a second, opposite side of said support means.

3. The probe of claim 1 which further includes:

a plurality of second conductor means having first and second ends, for coupling at their first ends to the terminations of the plurality of first conductor means;

mechanical contact means for removably connecting the second conductor means at their first ends to the first conductor means by mechanical contact; and

a plurality of connector means for connecting to the plurality of second conductor means at their second ends.

4. The probe of claim 3 in which the plurality of first conductor means comprises metal traces formed on the surface of the three dimensional insulating support means and in which the plurality of second conductor means comprises transmission line conductors operated in conjunction with a ground plane conductor.

5. The probe of claim 1 which further includes pressure means for cooperating to cause the plurality of electrical contact means resiliently to deflect when said plurality of contact means is pressed against the integrated circuit.

6. The probe of claim 5 in which the pressure means includes:

an inelastic member; and

elastic means for elastically coupling the contact supporting portion of the three dimensional insulating support means to the inelastic member, whereby pressure applied by the integrated circuit to the plurality of electrical contact means causes the elastic means to compress.

7. The probe of claim 1 in which the three dimensional insulating support means comprises an insulating material having a substantially truncated pyramidal geometry including four trapezoidally shaped sides each having a short edge at the truncation and a parallel larger edge at the pyramidal base.

8. The probe of claim 7 in which the three dimensional insulating support means includes an insulated truncation surface connecting the four short edges, said insulated trucation surface comprising the contact supporting portion of the three dimensional support means.

9. The probe of claim 1 in which the electrical contact supporting portion of the three dimensional insulating support means defines an orifice through which marking ink can be applied to the integrated circuit.

10. An integrated circuit probing system comprising:

a support member;

a plurality of coplanar transmission lines bonded to the support member and originating near a central region thereof, each of said transmission lines comprising a transmission line conductor operated in conjunction with a ground conductor;

probe means including:

a plurality of electrical contacts for contacting the integrated circuit;

a probe structural member onto which the plurality of electrical contacts are mounted; and

a plurality of probe conductors bonded to the probe structural member for coupling to the plurality of electrical contacts;

the probing system further comprising mounting means for removably mounting the probe head means in the central region of the common member so that the probe conductors make pressure contact with the transmission line conductors.

11. The probing system of claim 10 in which:

the probe structural member includes a planar peripheral lip;

the probe conductors are formed on a surface of the structural member and terminate on the planar peripheral, i.e.;

the transmission line conductors are exposed at their originations near the central region of the support member; and

the mounting means comprises means for pressing the coplanar probe conductor terminations against the coplanar transmission line conductor originations.

12. The probing system of claim 10 which further includes interface means for connecting the transmission lines to semirigid coaxial cables which have been cut at their ends to expose a planar surface including the center conductor and the outer conductor, said interface means including:

receiving means for receiving the uncut, semicircular side of each semirigid coaxial cable; and

clamping means for clamping the planar surface of each semirigid cable against a corresponding planar transmission line so that mechanical contact is established between the corresponding elements of the semirigid cable and the planar transmission line.

13. The probing system of claim 12 in which:

the support member comprises a planar insulating substrate;

the transmission lines comprise a plurality of radially extending coplanar conductors bonded to the insulating substrate operated in conjunction with a ground plane formed on the same insulating substrate intermediate the plurality of conductors; and

the interface means includes means for establishing mechanical contact between the center conductor of each semirigid coaxial cable and one of the coplanar conductors on the insulating substrate and further establishing mechanical contact between the ground conductor of each semirigid coaxial cable and the ground plane formed on the insulating substrate.

14. An apparatus for coupling a plurality of coplanar transmission lines that terminate near the edge of an insulating substrate to a plurality of semirigid coaxial cables which have been cut at their ends to expose a planar surface including the center conductor and the outer conductor, comprising:

receiving means having a plurality of recesses for receiving the uncut, circular side of each semirigid coaxial cable;

rib means for urging the planar surface of each semirigid coaxial cable against a corresponding coplanar transmission line; and

clamping means for compressing the rib means towards the receiving means so that mechanical contact is established between the center conductor of the semirigid coaxial cable and the corresponding conductor in the coplanar transmission line, the clamping means further including means for establishing mechanical contact between the ground conductor of the semirigid coaxial cable and the corresponding ground plane on the coplanar transmission line.

15. A method for coupling a plurality of coplanar transmission lines to a plurality of semirigid coaxial cables comprising the steps:

cutting each semirigid coaxial cable at its end along a plane substantially parallel to the longitudinal axis of the cable so as to expose a planar surface including the center conductor and the outer conductor;

positioning each cut end of a semirigid cable against a corresponding termination of a coplanar transmission line along the edge of the insulating substrate; and

pressing the exposed planar surface of the semirigid coaxial cable against the coplanar transmission line so as to establish contact between the ground of the semirigid coaxial cable and the ground plane of the coplanar transmission line, and so as to establish contact between the center conductor of the semirigid coaxial cable and the unbalanced conductor of the coplanar transmission line.

16. In a wafer probing system having a probe head with opposed first and second sides, the first side supporting a plurality of wafer contacting elements, an apparatus for moderating the force applied to the wafer by the wafer contacting elements, comprising:

an elastic member having opposed first and second sides;

coupling means coupling the first side of the elastic member to the second side of the probe head; and

securing means for holding the second side of the elastic member in a fixed position, so that force applied by the wafer contacts to the wafer causes the elastic member to compress, thereby moderating the force applied to the wafer.

17. The apparatus of claim 16 in which the coupling means comprises an inelastic element having a planar surface, said inelastic element being interposed between the elastic member and the second side of the probe head with its planar surface adjacent the probe head.

18. The apparatus of claim 17 in which the probe head and the elastic element both include transparent materials and the elastic member defines a transparent path, so that the probe can be optically aligned over the wafer by observation through the apparatus.

F I G. I

0259163

FIG.2

FIG.3

FIG.4

FIG.5

FIG.6

FIG.7